# EUROPÄISCHE PATENTSCHRIFT

(11) **EP 2 126 998 B1**
(45) Veröffentlichungstag und Bekanntmachung des Hinweises auf die Patenterteilung: **19.10.2016**
(21) Anmeldenummer: 08734322.4
(22) Anmeldetag: 26.02.2008
(51) Int. Cl.: H01L 51/50

(54) **OLED MIT FARBKONVERSION**
OLED WITH COLOUR CONVERSION
OLED À CONVERSION DE COULEUR

(30) Priorität: 27.02.2007 DE 102007009530
(43) Veröffentlichungstag der Anmeldung: 02.12.2009
(73) Patentinhaber: OSRAM OLED GmbH, 93049 Regensburg (DE)
(72) Erfinder: PÄTZOLD, Ralph, 91154 Roth (DE); ARICI BOGNER, Elif, A-4062 Kirchberg-Thening (AT); HUNZE, Arvid, 91056 Erlangen (DE); HEUSER, Karsten, 91056 Erlangen (DE)
(74) Vertreter: Epping - Hermann - Fischer
(86) Internationale Anmeldenummer: PCT/DE2008/000341
(87) Internationale Veröffentlichungsnummer: WO 2008/104164

(56) Entgegenhaltungen:
- EP-A- 1 731 583
- WO-A-00/17903
- WO-A-01/66997
- WO-A-99/50916

## Beschreibung

Die Erfindung betrifft eine organische Leuchtdiode - OLED (organic light emitting diode) - mit einer Farbkonversationsschicht zum Umwandeln einer primär von der OLED erzeugten Strahlung einer ersten Wellenlänge in Strahlung und insbesondere in Licht einer zweiten längeren Wellenlänge, wie sie insbesondere als Beleuchtungselement oder als Display eingesetzt werden kann.

Die Verwendung von Farbkonversationsschichten ist eine bekannte Methode, aus der primär von der OLED erzeugten und üblicherweise monochromatischen Strahlung ein Spektrum einer gewünschten Lichtfarbe bzw. Lichtfarbmischung zu erzeugen. Ziel kann es dabei sein, weißes und insbesondere dem Tageslicht angenähertes Licht zu erzeugen, was am besten für Beleuchtungszwecke geeignet ist.

Für LEDs sind Farbkonversionsschichten bekannt, die einen in eine Polymerschicht dispergierten Farbstoff enthalten, der in der Lage ist, die Primärstrahlung der LED zu absorbieren und eine langwelligere Sekundärstrahlung zu erzeugen. Durch eine Kombination von drei Farbkonversionsschichten mit geeignet gewählten Emissionswellenlängen der Sekundärstrahlung bzw. dazu geeigneter Farbstoffe gelingt durch Farbmischung der Emissionswellenlängen eine Annäherung an das Tageslicht. Dabei sind auch die Dicke der einzelnen Farbkonversionsschichten und die Konzentration der darin dispergierten Farbstoffe geeignet auszuwählen.

Für die Verwendung dieser bekannten Farbkonversionsschichten bei OLEDs ist es jedoch nachteilig, dass mit deren Farbstoffen und der Polymermatrix weiteres empfindliches Material in die OLED eingebaut wird, was die Lebensdauer dieser Bauelemente weiter reduziert bzw. durch Zersetzung der organischen Bestandteile das Nachlassen der Leuchtstärke beschleunigt. Darüber hinaus führt unterschiedliches Altern der unterschiedlichen Farbkonversionsschichten zu einer frühzeitig einsetzenden unerwünschten Farbveränderung des resultierenden emittierten Gesamtspektrums.

Die Druckschrift WO 00/17903 A2 betrifft eine Farbkonversionsschicht mit anorganischen Konversionsmaterialien für ein Display, das auf einer organischen Leuchtdiode basiert.

Aus der Druckschrift EP 1 731 583 A1 sind eine fluoreszierende Farbkonversionsschicht und ein Licht emittierendes Bauteil mit einer solchen Farbkonversionsschicht bekannt.

In der Druckschrift WO 99/50916 A1 ist eine farbig oder weiß emittierende Leuchtdiode mit Quantendots beschrieben.

Eine Licht emittierende Vorrichtung mit Quantendots findet sich in der Druckschrift WO 01/66997 A2.

Aufgabe der vorliegenden Erfindung ist es, eine OLED mit einer Farbkonversionsschicht anzugeben, die die genannten Nachteile vermeidet.

Diese Aufgabe wird erfindungsgemäß durch eine OLED mit den Merkmalen von Anspruch 1 gelöst. Vorteilhafte Ausgestaltungen der Erfindung sind den weiteren Ansprüchen zu entnehmen.

Es wird eine OLED angegeben, die zumindest eine Farbkonversionsschicht aufweist, die Quantendots enthält.

Quantendots haben den Vorteil, dass sie anorganisch und in der Regel unempfindlich gegen Feuchtigkeit und Sauerstoff sind. Sie weisen eine definierte Emissionswellenlänge auf, die keiner Alterung unterworfen und auch photochemisch stabil ist. Sie haben gegenüber Farbkonversionsschichten mit Farbstoffen den weiteren Vorteil, dass sie eine wesentlich breitere Absorptionsbande gegenüber einer Primärstrahlung haben und praktisch alle im Bereich blauer OLEDs liegende kurzwelligere Strahlung absorbieren. Quantendots sind darüber hinaus einfach zu verarbeiten und bei der Herstellung bezüglich ihrer Emissionslänge und auch bezüglich der Breite ihrer Emissionsbande beliebig trimm-und einstellbar. Sie sind auch einfach zu verarbeiten und kommerziell erhältlich.

Es wird also eine OLED angegeben, die einen auf einem Substrat angeordneten Schichtaufbau aufweist, der zumindest Anode, Kathode und eine dazwischen angeordnete Funktionsschicht umfasst. Zumindest eine Elektrode, ausgewählt aus Anode und Kathode ist für das von der Funktionsschicht emittierte Licht durchlässig und auf der lichtemittierenden Seite - Emissionsseite - des Schichtaufbaus angeordnet. Die zumindest eine Farbkonversionsschicht mit den Quantendots ist auf der Emissionsseite über oder unter dem Schichtaufbau angeordnet.

Die zumindest eine Farbkonversionsschicht umfasst drei bezüglich ihrer Emissionswellenlänge unterschiedliche Quantendots. Diese Emissionswellenlängen sind so gewählt, dass deren addiertes Gesamt-Emissionsspektrum dem weißen Licht angenähert ist. Auf diese Weise werden für Beleuchtungszwecke gut geeignete OLEDs erhalten.

Die Quantendots können in einer transparenten Matrix dispergiert sein, die z.B. ein organisches Polymer umfasst. Möglich ist es jedoch auch, die als Nanopartikel oder als Suspension von Nanopartikeln vorliegenden Quantendots direkt zur Schichterzeugung der Farbkonversionsschicht zu verwenden. Zum mechanischen Schutz kann die Nanopartikel der Farbkonversionsschicht mit einer Abdeckung versehen werden, welche eine Polymerschicht, eine Folie oder ein festes transparentes Material umfassen kann.

Das den Schichtaufbau tragende Substrat kann transparent und auf der Emissionsseite angeordnet sein.

Die OLED ist auf der Emissionsseite mit einer Abdeckung versehen und verkapselt und die Farbkonversionsschicht ist auf dieser Abdeckung aufgebracht. Dies erfolgt vor der Verkapselung auf der Innenseite der Abdeckung.

Vorteilhaft umfassen Substrat und/oder Abdeckung eine Glasschicht. Glas hat den Vorteil, dass es transparent für emittierte Strahlung, kostengünstig, leicht verarbeitbar, diffusionsdicht und ausreichend mechanisch stabil ist. Zumindest eines aus Substrat und Abdeckung kann gegebenenfalls zusätzlich weitere Schichten umfassen und beispielsweise als Mehrschichtlaminat ausgebildet sein. Zumindest eines aus Substrat und Abdeckung ist für das von der OLED abgestrahlte Licht zumindest teilweise durchlässig.

Das Substrat, insbesondere wenn es nicht auf der Emissionsseite des Schichtaufbaus angeordnet ist, kann jedoch ein beliebiges festes gegebenenfalls sogar flexibles Material sein.

Umgekehrt kann die OLED auf fast beliebigen auf gekrümmten Oberflächen aufgebracht werden. Sie kann jedoch auch ein einzeln handhabbares Bauelement sein.

Die OLED kann auf eine beliebig große Substratfläche stufenlos skaliert werden. Der Grundriss kann beliebig gestaltet und einer gegebenen Verwendung angepasst sein. Er kann eine geometrisch regelmäßige Form annehmen wie z.B. ein Rechteck, Polygon, Kreis oder beliebig unregelmäßig sein.

Zwischen Abdeckung und Substrat kann über oder neben der der lichtabstrahlenden aktiven Fläche der OLED ein Hohlraum eingeschlossen sein, in dem ein Getter-Material angeordnet ist. Dieses ist so gewählt, dass es bei eindringender Feuchtigkeit und/oder eindringendem Sauerstoff eine Beschädigung des lichtemittierenden Elements bzw. der OLED verhindern oder zumindest über einen längeren Zeitraum verzögern kann. Das Getter-Material muss daher zur Absorption beziehungsweise zum Binden von Sauerstoff und/oder Feuchtigkeit geeignet sein und ist entsprechend ausgewählt.

Möglich ist es auch, das Getter-Material ohne Hohlraum direkt auf den Schichtaufbau vorzusehen.

Die Abdeckung kann den Schichtaufbau freitragend überspannen und nur außerhalb des aktiven Bereichs der OLED mit dem Substrat verbunden sein, z.B. mit einem Dicht- oder Klebemittel.

Bei größeren aktiven Flächen kann sich die Abdeckung auch auf dem Schichtaufbau abstützen. Dabei kann die gesamte aktive Fläche zum Abstützen dienen. Auf dem Schichtaufbau kann auch ganzflächig eine Klebstoffschicht oder ein Dichtmittel oder ein isolierendes Material aufgebracht und mit der Abdeckung verklebt sein.

Möglich ist jedoch auch, zumindest ein Abstützelement mit kleinerer Grundfläche zwischen Schichtaufbau und Abdeckung vorzusehen. Vorteilhaft ist zumindest im Bereich des zumindest einen Abstützelements zwischen Abstützelement und Schichtaufbau eine Pufferschicht vorgesehen, die insbesondere weich oder elastisch mit niedrigem E-Modul ausgebildet ist, um Beschädigungen des Schichtaufbaus durch die auf ihn einwirkenden Abstützkräfte zu vermeiden.

Im Folgenden wird die Erfindung anhand eines Ausführungsbeispiels sowie anhand von Abwandlungen und der dazugehörigen Figuren näher erläutert. Die Figuren dienen allein der Veranschaulichung der Erfindung und sind nur schematisch und nicht maßstabsgetreu ausgeführt.
Figuren 1 bis 7 zeigen verschiedene OLEDs mit einer Farbkonversionsschicht
Figuren 8 und 9 zeigen mögliche Schichtaufbauten für die OLED
Figur 10 zeigt einen Schichtaufbau mit einer aus Teilschichten bestehenden Farbkonversionsschicht.

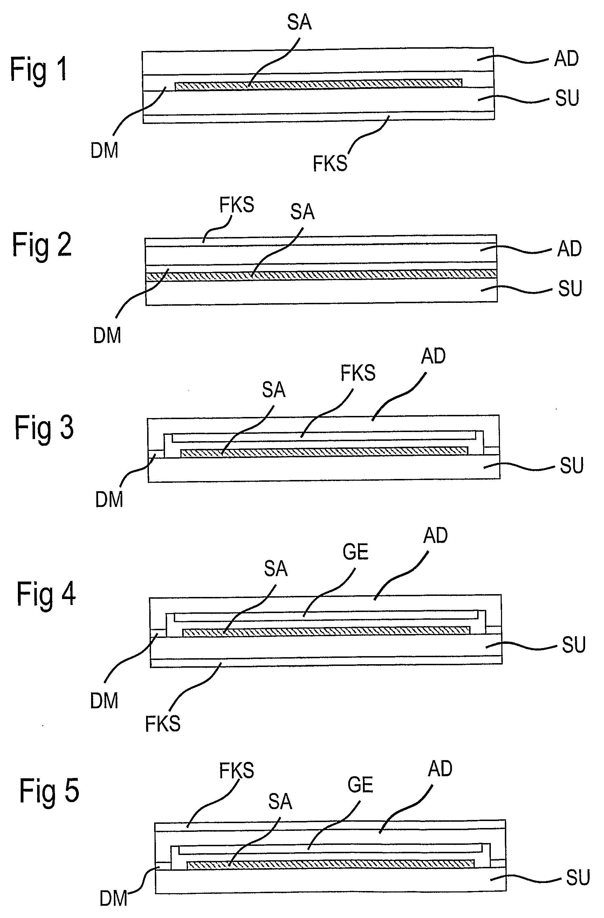

Figur 1 zeigt eine nicht erfindungsgemäße Abwandlung einer an sich bekannten OLED, welche als Schichtaufbau SA auf einem Substrat SU aufgebaut ist. Mit Hilfe eines Dichtmittels DM ist eine Abdeckung AD über der OLED angeordnet, wobei der Schichtaufbau von dem Dichtmittel abgedeckt ist. Zusätzlich weist die OLED eine Farbkonversionsschicht FKS auf, die direkt auf der Unterseite des Substrat SU aufgebracht ist, welches hier transparent ausgebildet ist und daher die lichtemittierende Seite darstellt.

Figur 2 zeigt eine nicht erfindungsgemäße Abwandlung einer ähnlichen OLED, bei der im Unterschied zu Figur 1 die Farbkonversionsschicht FKS auf der Abdeckung AD aufgebracht ist, die hier transparent ist und die lichtemittierende Seite darstellt.

Figur 3 zeigt ein Ausführungsbeispiel einer OLED, bei der die Abdeckung AD kappenartig ausgebildet ist und den Schichtaufbau SA berührungsfrei überdeckt. Das Dichtmittel DM ist hier auf den Auflagebereich der Abdeckung AD auf dem Substrat SU beschränkt. Auf der Innenseite der Abdeckung AD kann ein Getter-Material GE aufgebracht sein. Zusätzlich ist auf der Oberseite der hier transparent ausgebildeten Abdeckung AD die Farbkonversionsschicht FKS angeordnet.

Figur 4 zeigt eine nicht erfindungsgemäße Abwandlung einer ähnlich wie in Figur 3 ausgebildeten OLED, bei der im Unterschied zu Figur 3 die Farbkonversionsschicht FKS auf der Unterseite des Substrats SU angeordnet ist, wobei das Substrat hier transparent ist und die lichtemittierende Seite darstellt. Auf der Innenseite der Abdeckung AD, die über dem Schichtaufbau SA einen Hohlraum einschließt, kann ein Getter-Material GE aufgebracht sein.

Figur 5 zeigt eine nicht erfindungsgemäße Abwandlung einer ähnlich wie in Figur 4 ausgebildeten OLED, bei der im Unterschied zu Figur 3 die Farbkonversionsschicht FKS auf der Oberseite der Abdeckung AD angeordnet ist, die hier transparent ist und die lichtemittierende Seite darstellt. Auf kann auf der Innenseite der Abdeckung AD ein Getter-Material GE aufgebracht sein.

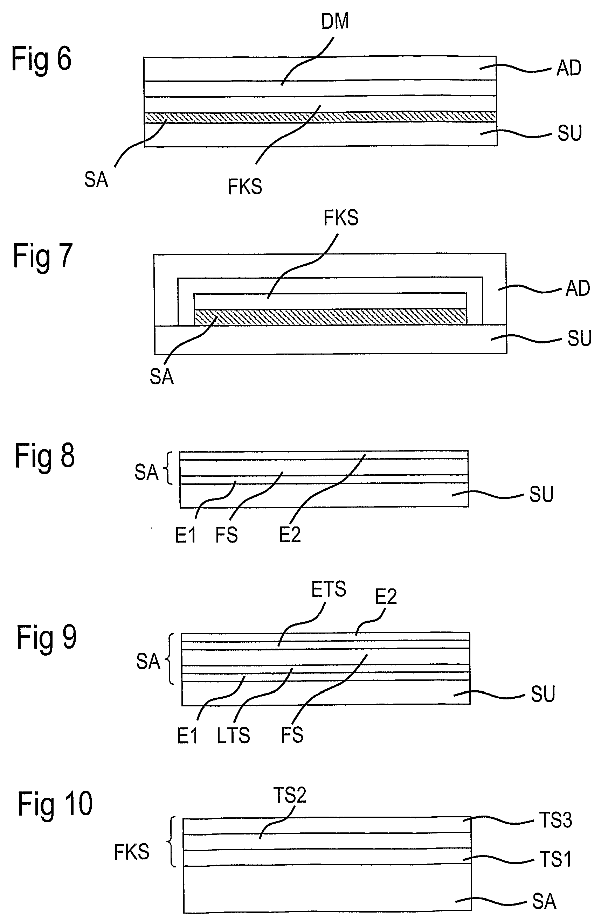

Figur 6 und Figur 7 zeigen nicht erfindungsgemäße Abwandlungen einer OLED, bei der die Farbkonversionsschicht FKS direkt auf den Schichtaufbau SA aufgebracht ist. Figur 6 zeigt eine direkt auf der eine Farbkonversionsschicht FKS aufliegende Abdeckung AD, während Figur 7 einen unter der Abdeckung den Schichtaufbau SA einschließenden Hohlraum zeigt. Zwischen Farbkonversionsschicht FKS und Abdeckung AD kann in einem Aufbau ähnlich wie in Figur 6 noch eine abdichtende oder haftungsvermittelnde Schicht (nicht dargestellt) vorgesehen sein.

Figur 8 zeigt eine nicht erfindungsgemäße Abwandlung eines an sich bekannten möglichen Aufbaus einer OLED. Die OLED hat einen Schichtaufbau SA, der eine organische Funktionsschicht FS oder eine Schichtenfolge mit zumindest einer organischen Schicht aufweisen kann mit einem aktiven Bereich, der im Betrieb elektromagnetische Strahlung aussenden kann. Dies ist eine Schicht, die zumindest einen Farbstoff enthält oder in seltenen Fällen nur aus einem Farbstoff besteht.

Weiterhin kann die OLED eine auf dem Substrat SU aufgebrachte erste Elektrode E1 und auf dem Schichtaufbau SA eine zweite Elektrode ES aufweisen, wobei die Funktionsschicht(en) mit dem aktiven Bereich zwischen der ersten und zweiten Elektrode angeordnet sein kann. Vorzugsweise stellt die auf einem transparenten Substrat SU aufliegende erste Elektrode E1 die Anode dar, während die zweite nicht unbedingt transparent ausgeführte Elektrode E2 die Kathode darstellt.

Die Elektroden können eine der Grundfläche der OLED entsprechende einzige zusammenhängende Grundfläche aufweisen, die bereits mit je einer elektrisch Zuleitung angesteuert werden kann, so dass die OLED mit ihrer gesamten aktiven Fläche (Grundfläche) Licht emittieren kann.

Möglich ist es jedoch auch, entweder nur eine oder beide Elektroden durch Strukturieren in kleinere Teilflächen aufzuteilen. Diese Teilflächen können dann auch elektrisch einzeln und werden. Möglich ist es jedoch auch, den gesamten Schichtaufbau der OLED zu strukturieren, um die gewünschten entsprechenden Teilflächen zu erhalten.

Eine im unabhängig ansteuerbare Teilflächen strukturierte OLED kann auch Teilflächen mit unterschiedlichen Farbkonversionsschichten aufweisen. So ist es möglich, neben einheitlich emittierenden Flächen auch aus mehreren unterschiedlich emittierenden Teilflächen bunte Gesamtflächen zu erzeugen, mit denen die Darstellung von Bildern, Symbolen und Mustern gelingt.

Eine transparente erste Elektrode E1, die als Anode ausgeführt sein kann und somit als positive Ladungen oder "Löcher" injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metall-Sauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin müssen die TCOs nicht zwingend einer stöchiometrischen Zusammensetzung entsprechen und können auch p-oder n-dotiert sein. Alternativ oder zusätzlich kann die erste Elektrode auch ein Metall, beispielsweise Silber, aufweisen.

Eine nicht transparente Kathode kann aus einem Metall oder Legierung mit geringer Elektronenaustrittsarbeit bestehen und zum Beispiel Aluminium, Barium, Ruthenium, Indium, Silber, Gold, Magnesium, Calcium oder Lithium sowie Verbindungen, Kombinationen und Legierungen davon umfassen.

Der in Figur 8 dargestellte Schichtaufbau SA kann auch invertiert sein, so dass die erste Elektrode E1 die nicht transparente Kathode und die zweite Elektrode E2 die transparente Anode auf der Emissionsseite darstellt.

Die erste und die zweite Elektrode injizieren "Löcher" beziehungsweise Elektronen in den aktiven Bereich, die dort unter Ausbildung eines angeregten Zustands rekombinieren können. Dessen Energie wird dann auf den Farbstoff der Funktionsschicht FS übertragen, der dann in einen elektronisch angeregten Zustand übergeht. Unter Emission von elektromagnetischer Strahlung bzw. Licht geht der Farbstoff dann in einen energetisch niedriger gelegenen Zustand oder den Grundzustand über.

Figur 9 zeigt einen weiter verfeinerten Schichtaufbau SA, zwischen Anode (erster Elektrode E1) und Funktionsschicht FS eine Lochleitungsschicht LTS und zwischen Funktionsschicht und Kathode (zweite Elektrode E2) eine Elektronentransportschicht oder eine Elektronen injizierende Schicht ETS angeordnet ist. Eine weitere Schicht kann zwischen Funktionsschicht FS und Lochleitungsschicht LTS vorgesehen sein und zur Absenkung der Injektionsbarriere für Löcher dienen.

Als Schutzschicht und zur Verringerung der Injektionsbarriere für Elektronen kann zwischen Kathode und Elektronentransportschicht ETS noch eine dünne Schicht aus LiF oder CsF aufgedampft sein.

Figur 10 zeigt einen erfindungsgemäßen Aufbau einer aus drei Teilschichten zusammengesetzten Farbkonversionsschicht FKS. Die Farbkonversionsschicht FKS umfasst hier eine erste Teilschicht TS1, die einen im Roten emittierenden Quantendot aufweist. Eine darüber (oder darunter) angeordnete zweite Teilschicht TS2, die weist einen orange emittierenden Quantendot auf. Die darüber (oder darunter) angeordnete dritte Teilschicht TS3 weist einen grün emittierenden Quantendot auf.

Die Teilschichten TS der Farbkonversionsschicht FKS können als Dispersion in einer polymeren Matrix aufgebracht werden, die gegebenenfalls nach dem Aufbringen aushärtet. Möglich ist jedoch auch die Nanopartikel der Quantendot als Suspension in einem Lösungsmittel aufzubringen, so dass nach Abdampfen des Lösungsmittels eine reine Nanopartikelschicht verbleibt, die eine Teilschicht darstellen kann.

Das Aufbringen der Dispersion oder Suspension kann durch Aufschleudern erfolgen. Die Dispersivität der Nanopartikel in der Matrix oder im Lösungsmittel ist dabei eine Funktion der Oberfläche, in die die Quantendots eingebettet sind. Beispielsweise sind in Triphenylphosphit eingebettete Quantendots in Acetonitril löslich, während in Tri-n-octylphosphin eingebettete Quantendots in einer nicht polaren Matrix oder einem solchen Lösungsmittel löslich bzw. dispergierbar sind. Geeignet ist z.B. Toluol.

Mittels Aufschleudern als Aufbringverfahren kann die erforderliche Anzahl von Teilschichten TSn (n≥3) gefahrlos direkt übereinander aufgebracht werden, ohne dass eine untere Teilschicht TSn-1 dabei beschädigt wird.

Die Quantendots haben eine nanoskopische Struktur und sind meist aus Halbleitermaterial (z.B. InGaAs, CdSe oder auch GaInP/InP). Die Ladungsträger (Elektronen, Löcher) in einem Quantendot sind in allen drei Raumdimensionen so weit eingeschränkt, dass ihre Energie nicht mehr kontinuierliche, sondern nur noch diskrete Werte annehmen kann. Diese Energie bzw. der Unterschied zwischen diskreten Energieniveaus des Quantendots bestimmt die Emissionswellenlänge des Quantendots.

Die Emissionswellenlänge des Quantendots ist dabei eine Funktion der Größe des Quantendots. Sie kann ein schmales Gauss'sches Emissionsband zeigen, das z.B. für CdSe Nanopartikel eines Durchmessers von 2 nm ein Maximum bei 520 nm aufweist. Der gleiche Nanopartikel dagegen mit einem Durchmessers von 6 nm zeigt ein Emissionsmaximum bei 640 nm. Das heißt, dass die Quantendots maßgeschneidert auf eine bestimmte Emissionswellenlänge hin hergestellt werden können. Dies ist ein weiterer Vorteil gegenüber Farbkonversionsschichten mit Farbstoffen, wobei dort für jede Teilschicht erst der richtige zur Wellenlänge passende Farbstoff gefunden werden muss, also z.B. drei verschiedene Farbstoffe, die dann ach noch unterschiedlich absorbieren.

Bei enger Partikelgrößenverteilung der Quantendots in einer Teilschicht (Trägersubstrat) kann eine schmale Emissionsbande mit dieser Teilschicht erhalten werden, die z.B. eine FWHM Breite (full width at half maximum) von weniger als 40 nm aufweist.

Das Absorptionsspektrum der Quantendots dagegen hängt in nur geringem Maß von ihrem Durchmesser ab, so dass alle unterschiedlichen Quantendots in den Teilschichten TS der Farbkonversionsschicht FKS mit der gleichen Wellenlänge angeregt werden können. Die Anregungswellenlänge wird vorzugsweise im Blauen bei ca. 300 bis 450 nm ausgewählt, allein weil blau mittels einer Farbkonversionsschicht in alle anderen langwelligeren Farben konvertiert werden kann.

Die Dicke der Farbkonversionsschicht FKS bzw. jeder ihrer Teilschichten TS kann leicht durch die Parameter des Aufschleuderverfahrens eingestellt werden, so dass eine gewünschte Mischfarbe aus den einzelnen Emissionswellenlängen der Teilschichten auch exakt eingestellt und erhalten werden kann.

Es ist möglich, in einzelnen Figuren dargestellte Einzelmerkmale mit in anderen Figuren dargestellten Merkmalen zu kombinieren. Die genaue Gestaltung des Schichtaufbaus SA, der Abdeckung AD, die Art und Ausgestaltung des Substrats SU und die Größenverhältnisse können von den in den Figuren dargestellten Ausführungen abweichen. Soweit Materialangaben bezüglich der einzelnen Elemente der erfindungsgemäßen OLED gemacht wurden, so sind diese doch nicht bindend. Insbesondere ist es möglich, für einzelne Komponenten der Vorrichtung, soweit diese mit bekannten Vorrichtungen übereinstimmen, die entsprechenden bekannten Materialien einzusetzen.

Die OLED kann zu Beleuchtungszwecken mit weißer Mischfarbe emittierend eingesetzt werden.

Substrat SU, und die Größenverhältnisse können von den in den Figuren dargestellten Ausführungen abweichen. Soweit Materialangaben bezüglich der einzelnen Elemente der erfindungsgemäßen OLED gemacht wurden, so sind diese doch nicht bindend. Insbesondere ist es möglich, für einzelne Komponenten der Vorrichtung, soweit diese mit bekannten Vorrichtungen übereinstimmen, die entsprechenden bekannten Materialien einzusetzen.

Die OLED kann zu Beleuchtungszwecken vorwiegend mit weißer Mischfarbe emittierend eingesetzt werden. Die Farbkonversationsschicht bzw. deren Teilschichten kann jedoch auch eine andere resultierende Lichtfarbe ergeben, so dass auch z.B. dekorative Anwendungen und darstellende Abbildungen mit der OLED erzeugt werden können. Mit einer strukturierten OLED mit einzeln ansteuerbaren Teilflächen, die unterschiedliche mittels unterschiedlicher Farbkonversationsschichten erzeugte Lichtfarben emittieren, lassen sich auch bunte und animierte Lichteffekte erzielen.

## Patentansprüche

1. OLED, aufweisend einen auf einem Substrat (SU)
angeordneten Schichtaufbau (SA) aus zumindest
Anode, Kathode und einer dazwischen angeordneten Funktionsschicht (FS),
wobei zumindest eine Elektrode (E), ausgewählt aus Anode und Kathode für das von der Funktionsschicht emittierte Licht durchlässig und auf der Emissionsseite des Schichtaufbau angeordnet ist,
wobei die OLED zumindest eine auf der Emissionsseite über oder unter dem Schichtaufbau angeordnete, als Farbkonversionsschicht (FKS) dienende Schicht aufweist, die Quantendots enthält,
wobei
- die zumindest eine Farbkonversionsschicht (FKS) mindestens drei bezüglich ihrer Emissionswellenlänge unterschiedliche Quantendots aufweist, deren addiertes Gesamt-Emissionsspektrum dem weißen Licht angenähert ist,
- zumindest drei Teilschichten (TS) die Farbkonversionsschicht (FKS) bilden und übereinander angeordnet sind,
- die Teilschichten (TS) jeweils eine Sorte der Quantendots mit einer dieser Sorte zugewiesenen Emissionswellenlänge enthalten und sich die Emissionswellenlängen der Quantendots in den zumindest drei Teilschichten (TS) der Farbkonversionsschicht (FKS) voneinander unterscheiden,
- der Schichtaufbau (SA) zwischen dem Substrat (SU) und einer Abdeckung (AD) gekapselt ist, und- die zumindest eine Farbkonversionsschicht (FKS) auf einer zum Schichtaufbau (SA) weisenden Innenseite der Abdeckung (AD) aufgebracht ist.

2. OLED nach Anspruch 1,
bei der die Quantendots in einer transparenten Matrix dispergiert sind.

3. OLED nach einem der Ansprüche 1 - 2,
bei der die Quantendots in einer transparenten Matrix aus einem organischen Polymer enthalten sind.

4. OLED nach einem der Ansprüche 1 - 3,
bei der die Quantendots als Nanopartikelschicht aufgebracht und mit einer transparenten Schutzschicht abgedeckt sind.

5. OLED nach einem der Ansprüche 1 - 4,
bei der das den Schichtaufbau (SA) tragende Substrat (SU) transparent und auf der Emissionsseite angeordnet ist, und bei der die Farbkonversionsschicht (FKS) auf dem Substrat aufgebracht ist.

6. OLED nach einem der Ansprüche 1 - 4,
bei der die Emissionsseite der dem Substrat (SU) gegenüberliegenden Seite des Schichtaufbaus (SA) entspricht und bei der die Farbkonversionsschicht (FKS) auf der transparenten Elektrode (E1) angeordnet ist.

7. OLED nach einem der vorhergehenden Ansprüche,
bei der Substrat (SU) und Abdeckung (AD) eine Glasschicht umfassen.

## Claims

1. OLED, comprising a layer construction (SA) composed of at least anode, cathode and a functional layer (FS) arranged in between, said layer construction being arranged on a substrate (SU),
wherein at least one electrode (E), selected from anode and cathode, is transmissive to the light emitted by the functional layer and is arranged on the emission side of the layer construction,
wherein the OLED has at least one layer which is arranged on the emission side above or below the layer construction, serves as a colour conversion layer (FKS) and contains quantum dots,
wherein
- the at least one colour conversion layer (FKS) has at least three quantum dots which differ with regard to their emission wavelength and whose added total emission spectrum is approximated to white light,
- at least three partial layers (TS) form the colour conversion layer (FKS) and are arranged one above another,
- the partial layers (TS) respectively contain a type of the quantum dots having an emission wavelength allocated to said type and the quantum dots in the at least three partial layers (TS) of the colour conversion layer (FKS) have different emission wavelengths from one another,
- the layer construction (SA) is encapsulated between the substrate (SU) and a covering (AD), and
- the at least one colour conversion layer (FKS) is applied on an inner side of the covering (AD) facing the layer construction (SA).

2. OLED according to Claim 1,
in which the quantum dots are dispersed in a transparent matrix.

3. OLED according to either of Claims 1 - 2,
in which the quantum dots are contained in a transparent matrix composed of an organic polymer.

4. OLED according to one of Claims 1 - 3,
in which the quantum dots are applied as a nanoparticle layer and covered with a transparent protective layer.

5. OLED according to one of Claims 1 - 4,
in which the substrate (SU) carrying the layer construction (SA) is transparent and arranged on the emission side, and
in which the colour conversion layer (FKS) is applied on the substrate.

6. OLED according to one of Claims 1 - 4,
in which the emission side corresponds to the side of the layer construction (SA) opposite to the substrate (SU), and
in which the colour conversion layer (FKS) is arranged on the transparent electrode (E1).

7. OLED according to one of the preceding claims,
in which the substrate (SU) and covering (AD) comprise a glass layer.

## Revendications

1. OLED, présentant une structure stratifiée (SA) disposée sur un substrat (SU), composée d'une anode, d'une cathode et d'une couche fonctionnelle (FS) disposée entre celles-ci, dans laquelle au moins une électrode (E), choisie parmi l'anode et la cathode, est transparente pour la lumière émise par la couche fonctionnelle et est disposée sur le côté d'émission de la structure stratifiée,
dans laquelle l'OLED présente au moins une couche disposée sur le côté d'émission, au-dessus ou en dessous de la structure stratifiée, et servant de couche de conversion de couleur (FKS), qui contient des boîtes quantiques,
dans laquelle
- ladite au moins une couche de conversion de couleur (FKS) présente au moins trois boîtes quantiques différentes au niveau de leur longueur d'onde d'émission, dont le spectre d'émission total cumulé est proche de la lumière blanche,
- au moins trois couches partielles (TS) forment la couche de conversion de couleur (FKS) et sont disposées l'une au-dessus de l'autre,
- les couches partielles (TS) contiennent chacune une sorte des boîtes quantiques avec une longueur d'onde d'émission attribuée à cette sorte et les longueurs d'onde d'émission des boîtes quantiques dans lesdites au moins trois couches partielles (TS) de la couche de conversion de couleur (FKS) diffèrent l'une de l'autre,
- la structure stratifiée (SA) est coincée entre le substrat (SU) et un recouvrement (AD), et
- ladite au moins une couche de conversion de couleur (FKS) est déposée sur un côté intérieur du recouvrement (AD) tourné vers la structure stratifiée (SA).

2. OLED selon la revendication 1, dans laquelle les boîtes quantiques sont dispersées dans une matrice transparente.

3. OLED selon une des revendications 1 ou 2, dans laquelle les boîtes quantiques sont contenues dans une matrice transparente en un polymère organique.

4. OLED selon l'une quelconque des revendications 1 à 3, dans laquelle les boîtes quantiques sont déposées sous forme de couche de nanoparticules et sont recouvertes par une couche de protection transparente.

5. OLED selon l'une quelconque des revendications 1 à 4, dans laquelle le substrat (SU) portant la structure stratifiée (SA) est transparent et est disposé sur le côté d'émission, et dans laquelle la couche de conversion de couleur (FKS) est déposée sur le substrat.

6. OLED selon l'une quelconque des revendications 1 à 4, dans laquelle le côté d'émission correspond au côté de la structure stratifiée (SA) détourné du substrat (SU) et dans laquelle la couche de conversion de couleur (FKS) est disposée sur l'électrode transparente (E1).

7. OLED selon l'une quelconque des revendications précédentes, dans laquelle le substrat (SU) et le recouvrement (AD) comprennent une couche de verre.
